**Europäisches Patentamt**

**European Patent Office**

**Office européen des brevets**

(19)

(11) Publication number : **0 499 866 A1**

# (12) EUROPEAN PATENT APPLICATION

(21) Application number : **92101722.4**

(22) Date of filing : **03.02.92**

(51) Int. Cl.$^5$ : **H03K 5/08,** H03K 5/153

italian priority No. TO91A000106.

(30) Priority : **15.02.91**

(43) Date of publication of application :
**26.08.92 Bulletin 92/35**

(84) Designated Contracting States :
**DE FR GB SE**

(71) Applicant : **SGS-THOMSON
MICROELECTRONICS s.r.l.
Via C. Olivetti, 2
I-20041 Agrate Brianza Milano (IT)**

(72) Inventor : **Cassis, Marco
Via Casluncio, 60
I-21100 S. Ambrogio (IT)**
Inventor : **Rossi, Domenico
Via Roma, 16
I-27024 Cilavegna (IT)**
Inventor : **Onetti, Andrea
Via Cavallotti, 9
I-27100 Pavia (IT)**

(74) Representative : **Cerbaro, Elena et al
c/o Studio Torta, Via Viotti 9
I-10121 Torino (IT)**

(54) **Circuit for detecting the zero crossing of an alternating analog voltage.**

(57) A circuit (15) for detecting, with minimum offset, the zero crossing of the alternating analog output voltage of a switched-condenser filter (3). The circuit (15) comprises a smoothing filter (20) connected to the output of the switched-condenser filter (3) and generating a smoothed alternating signal ; a low-pass filter (21), also connected to the output of the switched-condenser filter (3), for detecting the direct-current offset of the alternating signal ; and a comparator (12), input connected to the smoothing filter (20) and the low-pass filter (21), for comparing the smoothed alternating signal with the direct-current offset, and so determining the zero-crossing of the smoothed alternating signal (sinusoid).

Fig.1

EP 0 499 866 A1

The present invention relates to a circuit for detecting the zero crossing of the alternating analog output voltage of a switched-condenser filter.

Circuits of the aforementioned type are used, for example, on the receiving filters of systems for transmitting digital data transmitted in analog mode with amplitude modulation and PSK (Phase Shift Keying) coding. Such data comprises, for example, auxiliary information relative to traffic, weather forecasts, and available radio stations, and is superimposed (with a carrier) on the usual radio signal. When received, the auxiliary signal is extracted from the incoming signal; sampled via a switched-condenser filter; smoothed by a so-called smoothing filter to reconstruct the information, by eliminating the high-frequency components, a multiple of the sampling frequency; and then processed to identify the coded binary information. In particular, processing requires that the zero crossing of the smoothed signal be determined, to evidence phase shifting $\pi$ (phase inversion) of the sinusoid coding the information (0 or 1 bit).

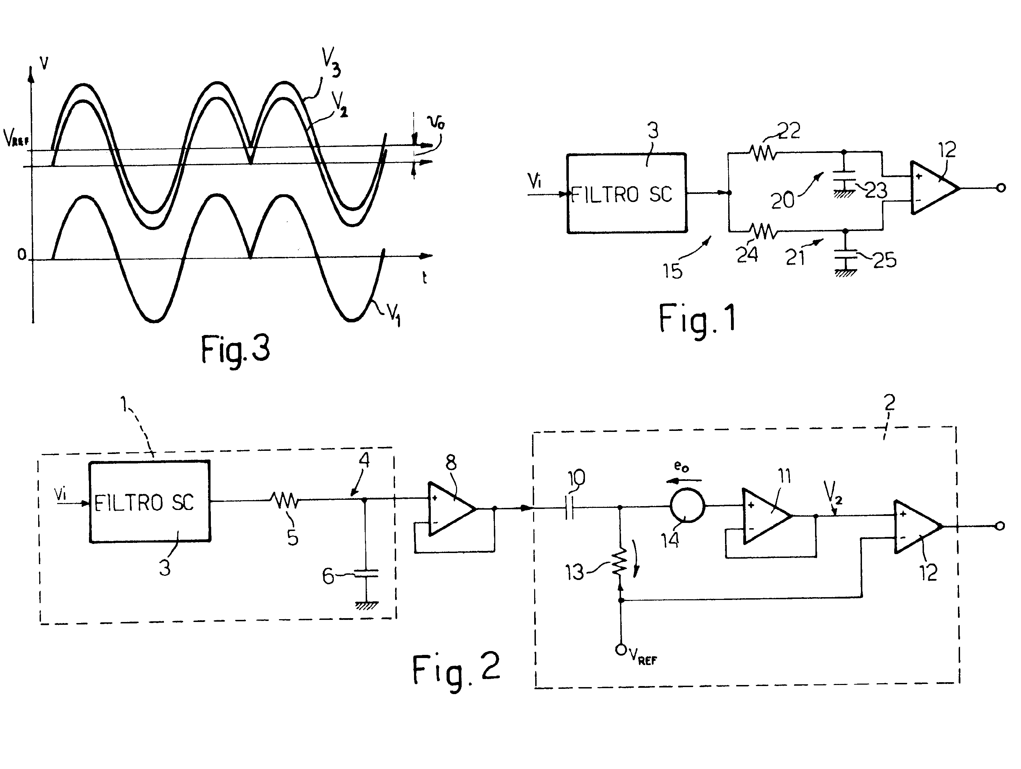

For this purpose, the receiver is fitted inside with a circuit comprising smoothing and zero-crossing detecting stages, a known embodiment of which is shown in Fig.2 and described briefly below.

Numbers 1 and 2 in Fig.2 respectively indicate the signal smoothing stage and zero-crossing detecting circuit. Stage 1, receiving input signal $V_i$, comprises a known SC (switched-condenser) filter 3, and a smoothing filter 4 comprising a resistor 5, series connected between the output of SC filter 3 and the output of stage 1, and a condenser 6 arranged between the output of stage 1 and ground. The output of stage 1 is connected to the non-inverting input of a buffer amplifier 8, the output of which is connected to the input of stage 2. Stage 2, in turn, comprises an input condenser 10 between the input of stage 2 and the non-inverting input of a buffer amplifier 11, the output of which is connected to its own inverting input, as well as to the non-inverting input of a zero-crossing detecting comparator 12. The inverting input of comparator 12 is connected to a reference potential $V_{REF}$ point also connected, via resistor 13, to the non-inverting input of buffer amplifier 11. Fig.2 also shows a voltage source 14 located between the non-inverting input of amplifier 11 and a terminal of resistor 13, and representing the direct-current offset voltage of buffer amplifier 11.

SC filter 3 represents a continuous-time circuit by which analog information is only supplied in the presence of a given value of the downstream filter (smoothing filter 4). That is, according to the sampling theorem, if $f_s$ is the sampling frequency of SC filter 3, smoothing filter 4 must be a low-pass type with a cutoff frequency $f_T < f_s/2$. The smoothed signal is then supplied to the zero-crossing detecting stage, for identifying the coded information bits. In the known stage shown in Fig.2, for ensuring reliable detection of the zero-crossing point, the smoothed signal is biased to reference voltage $V_{REF}$ of comparator 12, by adding to the alternating component of the signal a direct voltage equal to said reference.

The known solution in Fig.2, however, only provides for accurately determining the zero-crossing point in the absence of a direct-current offset in the stage upstream from comparator 12. Conversely, as normally occurs, in the presence of a direct-current offset in the upstream stage (represented in this case by buffer amplifier 11), the information supplied by comparator 12 is inaccurate. In particular, if $V_1$ is the alternating component of the smoothed signal at the input of stage 2; $V_2$ the analog output signal of buffer amplifier 11; $V_3$ the analog output signal of buffer amplifier 11 that would be obtained in the absence of a direct-current offset ($V_3 = V_1 + V_{REF}$); $e_o$ the direct-current offset voltage of buffer amplifier 11; and $I^+$ the bias current of amplifier 11; the offset $v_o$ introduced by amplifier 12 equals:

$$v_o = -I^+ - e_o$$

so that:

$$V_2 = V_3 + V_o = V_1 + V_{REF} - I^+ - e_o$$

Consequently, as shown in Fig.3, the exact zero-crossing point cannot be determined by comparing the real signal $V_2$ with reference voltage $V_{REF}$. Moreover, the error introduced by the stage upstream from the comparator is added to the offset caused by comparator 12 itself, thus further impairing the accuracy of the circuit as a whole.

It is an object of the present invention to provide a zero-crossing detecting circuit enabling a higher degree of operating precision as compared with known solutions. According to the present invention, there is provided a circuit for detecting the zero crossing of an alternating analog voltage, as claimed in Claim 1. A preferred, non-limiting embodiment of the present invention will be described by way of example with reference to the accompanying drawings, in which:

Fig.1 shows a simplified electric diagram of the circuit according to the present invention;
Fig.2 shows a simplified electric diagram of a known circuit;
Fig.3 shows a graph of a number of signals in the Fig.2 configuration.

In Fig.1, the circuit according to the present invention, indicated as a whole by 15, is connected to the output of SC filter 3, which is connected to two low-pass filters 20, 21, each connected to a respective input of zero-crossing comparator 12. Filter 20 comprises a resistor 22 series connected between the output of SC filter 3 and the non-inverting input of comparator 12; and a condenser 23 connected between said non-inverting input and ground (reference potential line). Filter 21 in turn comprises a resistor 24 series connected between the output of SC filter 3 and the inverting input of comparator 12; and a condenser 24 connected between said inverting input and ground. Both resistors 22 and 24 present the same resistance.

If R is the resistance of resistors 22 and 23; $C_1$ the capacitance of condenser 23; and $C_2$ the capacitance of condenser 24; filters 20 and 21 present respective cutoff frequencies $f_1$ and $f_2$ equal to:

$$f_1 = 1/(2\pi RC_1)$$
$$f_2 = 1/(2\pi RC_2).$$

In particular, filter 20 defines a smoothing filter, and filter 21 a low-pass filter for detecting the direct-current offset of the output signal from SC filter 3 (zero level of the smoothed analog alternating signal). This is achieved by making:

$$f_1 < f_s/2$$

according to the sampling theorem, so that the non-inverting input of comparator 12 presents the smoothed analog alternating signal coding the binary information; and by making:

$$f_2 << f_l$$

where $f_l$ is the frequency of analog alternating signal $V_l$ and therefore of the smoothed analog signal downstream from smoothing filter 20. The above conditions actually correspond to:

$$f_2 << f_1$$

and, as resistors 22 and 24 both present the same resistance, to:

$$C_2 >> C_1.$$

According to the present invention, therefore, the inverting terminal of the comparator is biased directly to the zero level (direct-current offset) of the alternating output signal of smoothing filter 20, and is thus linked exactly to the direct-current level present at the output of the smoothing filter itself. In other words, via filter 21, the circuit according to the present invention extracts the direct-current offset of the signal smoothed by filter 20, and uses it as a reference for comparator 12, thus enabling the latter to determine the zero crossing more accurately (with the exception of the direct-current offset of the comparator itself). In fact, by directly detecting the direct-current offset of the output signal from SC filter 3, said signal may be compared directly with said offset (which, as stated, represents its zero level) regardless of the origin of the offset itself, and, in particular, regardless of the offset of any stage or element upstream from the comparator.

Moreover, by providing for resistors 22 and 24 of the same value (to within an accuracy of over one per thousand using current integrated processes), bias currents $I^+$ and $I^-$ of the two inputs of comparator 12 may be made substantially equal, thus reducing the offset of comparator 12 itself.

The advantages of the Fig.1 circuit will be clear from the foregoing description. Firstly, it provides for greatly improving the accuracy with which the zero crossing is detected, thanks also to the elimination of the buffer stages featured in the known solution. Secondly, it is extremely straightforward in design, features far fewer component parts as compared with the known solution, and is thus more reliable and cheaper to produce.

Finally, it is fully integratable, by virtue of the frequencies employed also enabling integration of the condensers.

To those skilled in the art it will be clear that changes may be made to the circuit as described and illustrated herein without, however, departing from the scope of the present invention.

## Claims

1) - A circuit (15) for detecting the zero crossing of the alternating analog output voltage of a switched-condenser filter (3), said circuit comprising a smoothing filter (20) connected to the output of said switched-condenser filter, for producing an analog alternating signal; and a comparator (12) for comparing said analog alternating signal with a reference level; characterised by the fact that it comprises means (21) for detecting the direct-current offset of said analog alternating signal; said means (21) being connected to said comparator (12) and supplying said comparator (12) with said direct-current offset defining said reference level.

2) - A circuit as claimed in Claim 1, characterised by the fact that said means comprise a low-pass filter (21) connected to the output of said switched-condenser filter (3).

3) - A circuit as claimed in Claim 2, characterised by the fact that the cutoff frequency ($f_1$) of said smoothing filter (20) is less than half the sampling frequency ($f_s$) of said switched-condenser filter (3), and the cutoff frequency ($f_2$) of said low-pass filter (21) is much lower than the frequency ($f_1$) of said analog alternating signal.

4) - A circuit as claimed in one of the foregoing Claims from 1 to 3, wherein said comparator (12) comprises a first and second input; characterised by the fact that said smoothing filter (20) is located directly between the output of said switched-condenser filter (3) and said first input of said comparator (12); and said means are located directly between the output of said switched-condenser filter (3) and said second input of said comparator (12).

5) - A circuit as claimed in one of the foregoing Claims from 2 to 4, characterised by the fact that said smoothing filter (20) and said low-pass filter (21) each consist of an RC filter comprising a resistor (22, 24) and a condenser (23, 25); each said resistor (22, 24) being located between the output of said switched-condenser filter (3) and a respective input of said comparator (12); and each said condenser (23, 25) being located between a respective input of said comparator (12) and the same reference potential line.

**6)** - A circuit as claimed in Claim 5, characterised by the fact that the resistors (22, 24) of said smoothing filter (20) and said low-pass filter (21) present the same value (R).

**7)** - A circuit as claimed in Claim 5 or 6, characterised by the fact that the condenser (25) of said low-pass filler (21) presents a much higher capacitance ($C_2$) than the condenser (23) of said smoothing filter (20).

Fig.3

Fig.1

Fig.2

EP 0 499 866 A1

**European Patent Office**

# EUROPEAN SEARCH REPORT

Application Number

EP    92 10 1722

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | NEW ELECTRONICS, INCORPORATING ELECTRONICS TODAY. vol. 16, no. 15, 26 July 1983, LONDON GB page 18; ALAN LOCK: 'photodiode amp. with ambiant light rejection' * the whole document * | 1-7 | H03K5/08 H03K5/153 |
| A | ELECTRONIC ENGINEERING. vol. 55, no. 681, September 1983, LONDON GB page 31; K BAKER AND J COHEN: 'A simple sinusoidal / TTL converter' * the whole document * | 1-7 | |
| A | RESEARCH DISCLOSURE. no. 309, January 1990, NEW YORK, US page 30932; 'On Chip Clock Reciever Circuit' * the whole document * | 1-7 | |
| A | FUNK-TECHNIK. vol. 41, no. 12, December 1986, HEIDELBERG DE pages 531 - 532; M. ARNOLDT: 'Leistungsfähiger Tiefpass mit Schaltfiltern realisiert' * the whole document * | 1 | TECHNICAL FIELDS SEARCHED (Int. Cl.5 ) H03K H03H |

The present search report has been drawn up for all claims

| Place of search | Date of completion of the search | Examiner |
|---|---|---|
| THE HAGUE | 22 JUNE 1992 | SEGAERT P.A.O.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)